(19) **Europäisches Patentamt**

**European Patent Office**

**Office européen des brevets**

(11) **EP 1 321 440 B1**

(12) **EUROPÄISCHE PATENTSCHRIFT**

(45) Veröffentlichungstag und Bekanntmachung des
Hinweises auf die Patenterteilung:
**11.10.2006 Patentblatt 2006/41**

(51) Int Cl.:
*C03B 32/02* (2006.01)          *C03C 10/12* (2006.01)

(21) Anmeldenummer: **02028549.0**

(22) Anmeldetag: **20.12.2002**

(54) **Verfahren zur Herstellung eines Glaskeramischen Produktes**

Process for manufacturting a glass ceramic product

Procédé de fabrication d'un produit en vitrocéramique

(84) Benannte Vertragsstaaten:
**AT BE BG CH CY CZ DE DK EE ES FI FR GB GR
IE IT LI LU MC NL PT SE SI SK TR**

(30) Priorität: **21.12.2001 DE 10163597**

(43) Veröffentlichungstag der Anmeldung:
**25.06.2003 Patentblatt 2003/26**

(73) Patentinhaber: **Schott AG**
**55122 Mainz (DE)**

(72) Erfinder: **Mitra, Ina**
**55271 Stadecken-Elsheim (DE)**

(56) Entgegenhaltungen:
**US-A- 3 788 865**

• **J.W. BERTHOLD III AND S.F. JACOBS:
"Ultraprecise thermal expansion measurements
of seven low expansion materials" APPLIED
OPTICS, Bd. 15, Nr. 10, Oktober 1976 (1976-10),
Seiten 2344-2347, XP002276827**
• **J. PETZOLDT AND W. PANNHORST: "Chemistry
and structure of glass-ceramic materials for high
precision optical application" JOURNAL OF
NON-CRYSTALLINE SOLIDS, Bd. 129, 1991,
Seiten 191-198, XP002276828**
• **DAVIS M J ET AL: "Thermal expansion and
internal quality of a proposed EUVL mask
substrate material: Zerodur" PROC. SPIE - INT.
SOC. OPT. ENG. (USA), PROCEEDINGS OF THE
SPIE - THE INTERNATIONAL SOCIETY FOR
OPTICAL ENGINEERING, 2001, SPIE-INT. SOC.
OPT. ENG, USA, Bd. 4452, November 2001
(2001-11), Seiten 100-106, XP002276829 ISSN:
0277-786X**
• **SARKISOV P D ED - MAZURIN O V
INTERNATIONAL COMMISSION ON GLASS:
"THE MODERN STATE OF TECHNOLOGY AND
APPLICATION OF GLASS-CERAMICS" SURVEY
OF CONTEMPORARY GLASS SCIENCE AND
TECHNOLOGY. LENINGRAD, JULY 2, Bd.
SURVEY PAPERS. CONGRESS 15, 3. Juli 1989
(1989-07-03), Seiten 411-441, XP000075340**

**Beschreibung**

Die vorliegende Erfindung betrifft ein Verfahren zum Herstellen einer Glaskeramik mit einem definierten Nulldurchgang der CTE-T-Kurve (CTE: thermischer Ausdehnungskoeffizient), sowie die Verwendung eines solchen Verfahrens zur Herstellung eines glaskeramischen Produkts.

Transparente Glaskeramiken mit einem geringen thermischen Ausdehnungskoeffizienten sind seit langem im Stand der Technik bekannt und beispielsweise in DE 19 02 432 C, US 4,851,372 A und US 5,591,682 A beschrieben.

DE 19 02 432 C betrifft beispielsweise eine Glaskeramik im Zusammensetzungsbereich im System $Li_2O$ - $Al_2O_3$ - $SiO_2$, in dem durch Zusammensetzungsänderungen der Kristallphase während des Temperns keine merkliche Veränderung des Dehnungswerts einer Glaskeramik hervorgerufen wird. Als Ausführungsbeispiel sind Proben angegeben, welche für einen Zeitraum von 4 bis 100 h bei Temperaturen von 750°C bis 870°C keramisiert wurden. Die mittleren CTE der Proben, welche für die Temperaturintervalle [-30°C;+20°C] und [+20°C;+50°C] bestimmt wurden, wurden mit einer Genauigkeit von $\pm$ 0,02 $\times$ $10^{-6}$/K bestimmt.

Klassifiziert werden Glaskeramiken durch die Angabe des mittleren CTE [$t_0$;t] in einem Temperaturintervall von $t_0$ bis t.

Zerodur® wird beispielsweise in die folgenden drei Ausdehnungsklassen unterteilt, wobei die Werte den mittleren CTE [0°C;50°C] in einem Temperaturbereich von 0° C bis 50° C angeben:

- Klasse 0    0 $\pm$ 0,02 $\times$ $10^{-6}$/K
- Klasse 1    0 $\pm$ 0,05 $\times$ $10^{-6}$/K
- Klasse 2    0 $\pm$ 0,10 $\times$ $10^{-6}$/K

Für einige moderne Anwendungen ist jedoch diese Spezifikation nicht mehr ausreichend. Beispielsweise werden in der EUV(Extrem-UV)-Lithographie (EUVL) Substrate für Masken und Spiegel gefordert, welche einen mittleren CTE im Temperaturbereich von beispielsweise 19 bis 25°C von kleiner als 0 $\pm$ 5 ppb/K und eine Änderung des mittleren CTE in diesem Temperaturbereich $\Delta$ CTE < 6 ppb/K aufweisen.

US 6,048,654 beschreibt ein Verfahren zum Bilden einer Reflexionsschicht auf einem Substratmaterial, wie Zerodur® oder ULE, zur Herstellung einer reflektiven Photomask Blank für EUVL. Diese Schrift beschreibt jedoch kein Glaskeramikmaterial, dessen Nulldurchgang der CTE-T-Kurve auf die Anwendungstemperatur der aus dem Glaskeramikmaterial herzustellenden Photomaske abgestimmt ist.

US 5,591,682 und US 4,851,372 beschreiben jeweils verschiedene Glaskeramikzusammensetzungen, sowie deren jeweilige $\Delta$l/l-Kurve und den jeweiligen mittleren CTE. Diese Schriften beschreiben die Abhängigkeit des CTE von der Zusammensetzung Glaskeramik, nicht jedoch, wie der Nulldurchgang der CTE-T-Kurve einer Glaskeramik auf eine Anwendungstemperatur eingestellt werden kann. Diese Schriften beschreiben ferner nicht, dass bei gleicher Zusammensetzung einer Glaskeramik durch unterschiedliche Keramisierungszeiten und/oder -temperaturen Glaskeramiken mit unterschiedlichen Eigenschaften gezielt hergestellt werden können.

In dem Dokument J.W. Berthold III and S.F. Jacobs "Ultraprecise thermal expansion measurements of seven low expansion materials", Applied Optics, Bd. 15, Nr. 10, Oktober 1976, Seiten 234 bis 237, XP002276827, sind ultrapräzise Wärmeausdehnungsmessungen an sieben verschiedenen Materialien mit geringer Wärmeausdehnung darunter unter anderem Zerodur® beschrieben.

Bisher wurde angenommen, dass der CTE von Glaskeramiken nicht in genaueren, als den vorstehenden genannten Bereichen eingestellt werden kann.

Somit bestand die Aufgabe der vorliegenden Erfindung in der Bereitstellung eines Verfahrens, mit welchem glaskeramische Produkte hergestellt werden können, die den vorstehend genannten Erfordernissen genügen. Insbesondere sollte ein Verfahren bereitgestellt werden, welches es ermöglicht, jede Glaskeramik für eine bestimmte Anwendungstemperatur nutzbar zu machen, d.h. das Glaskeramikmaterial an die Anwendungstemperatur anzupassen. Ferner sollen glaskeramische Produkte bereitgestellt werden, welche die vorstehenden Spezifikationen erfüllen können.

Die vorstehende Aufgabe wird durch die in den Ansprüchen beschriebenen Ausführungsformen gelöst.

Insbesondere wird ein Verfahren zur Herstellung einer Glaskeramik aus dem System $Li_2O$ - $Al_2O_3$ - $SiO_2$ bereitgestellt, wobei die Glaskeramik hauptsächlich hoch-Quarz-haltige Mischkristalle enthält, deren Nulldurchgang der CTE-T-Kurve in einem Bereich $T_A$ $\pm$ 10°C um eine Anwendungstemperatur $T_A$ eingestellt ist, welches die Schritte

- Bereitstellen einer vorkeramisierten Glaskeramik , wobei das Vorkeramisieren die Kristallisationskeimbildung und Kristallwachstum umfasst, und
- Nachkeramisieren nach einem Keramisierungsprogramm und dadurch Einstellen des Nulldurchgangs der CTE-T-Kurve der Glaskeramik, wobei die Glaskeramik auf oder über die Keramisierungstemperatur erwärmt wird,

umfasst, wobei die Erstellung des Keramisierungsprogramms den Schritt Ermitteln der CTE-T-Kurve umfasst und wobei "CTE" für den thermischen Längenausdehnungskoeffizienten ($\alpha$) steht.

Die Figuren zeigen:

Figur 1 zeigt den Einfluss der Keramisierungstemperatur auf den mittleren CTE [-30°C;70°C] gemäß dem Stand der Technik.

Figur 2 zeigt eine Kurvenschar von Polynomen, welche durch Messpunkte von $\Delta l/l_0$-T-Messungen an verschieden keramisierten Zerodur®-Proben gelegt wurden.

Figuren 3 bis 7 zeigen jeweils in Figur a Polynome, welche durch Messpunkte von $\Delta l/l_0$-T-Messungen an Zerodur®-Proben gelegt wurden, sowie in der jeweiligen Figur b CTE-T-Kurven, welche durch Ableitung der Polynome aus der jeweiligen Figur a erhalten wurden. Die Figur 8 zeigt ein entsprechendes Diagramm einer Zerodur® M-Probe.

Das erfindungsgemäße Verfahren dient zum Herstellen von Glaskeramiken mit bestimmten thermischen bzw. temperaturabhängigen Längenänderungs- bzw. Dehnungseigenschaften bei einer Anwendungstemperatur $T_A$.

Unter der Anwendungstemperatur $T_A$ wird erfindungsgemäß die Temperatur bzw. der Temperaturbereich verstanden, welcher ein aus einer Glaskeramik hergestelltes glaskeramisches Produkt bei seiner bestimmungsgemäßen Anwendung ausgesetzt ist. Beispielsweise wird eine Photomaske oder ein Spiegel für die EUV-Lithographie bei der bei ihrer bestimmungsgemäßen Verwendung voraussichtlich einer Temperatur von 19 bis 33°C ausgesetzt sein. Dahingegen wird ein Spiegel für ein Weltraumteleskop bei seiner bestimmungsgemäßen Verwendung einer Temperatur nahe dem absoluten Nullpunkt ausgesetzt sein.

Es ist nun vorteilhaft, die Eigenschaften einer Glaskeramik so einzustellen, dass sie nahe der Anwendungstemperatur die größte Dimensionsstabilität aufweist. Je näher ein Nulldurchgang der CTE-T-Kurve einer Glaskeramik bei der Anwendungstemperatur der Glaskeramik liegt, umso geringer ist die Abweichung der Länge des Glaskeramikkörpers bei einer Änderung der Temperatur. Je weiter sich der Nulldurchgang der CTE-T-Kurve einer Glaskeramik von der Anwendungstemperatur entfernt, umso größer ist Längenänderung eines Körpers aus einer solchen Glaskeramik bei einer Temperaturänderung.

Mit dem erfindungsgemäßen Verfahren wird vorzugsweise eine Glaskeramik mit einem niedrigen mittleren Ausdehnungskoeffizienten bzw. CTE ("Coefficient of Thermal Expansion") bzw. ein Grünkörper, welcher in eine solche Glaskeramik mit einem niedrigen mittleren CTE umgewandelt werden kann, bereitgestellt.

Dabei wird unter einem "niedrigen mittleren CTE" ein Wert von vorzugsweise höchstens $0 \pm 1,0 \times 10^{-6}$/K, mehr bevorzugt höchstens $0 \pm 0,6 \times 10^{-6}$/K, noch bevorzugter höchstens $0 \pm 0,1 \times 10^{-6}$/K, am meisten bevorzugt höchstens $0 \pm 0,05 \times 10^{-6}$/K verstanden, welcher in einem Temperaturbereich um die Anwendungstemperatur $T_A$ gemessen wird, insbesondere ein mittlerer CTE [$T_A$-100°C; $T_A$+100°C], mehr bevorzugt mittlerer CTE [$T_A$-50°C; $T_A$+50°C].

Mit dem erfindungsgemäßen Verfahren kann der mittlere CTE auf einen Wert von beispielsweise höchstens $0,01 \times 10^{-6}$/K eingestellt werden.

Unter einer Glaskeramik werden erfindungsgemäß anorganische, nicht poröse Materialien mit einer kristallinen Phase und einer glasigen Phase verstanden, wobei in der Regel die Matrix, d.h. die kontinuierliche Phase, eine Glasphase ist.

Die Kombination aus kristalliner Phase und Glasphase verleiht einer Glaskeramik ihre besonderen Eigenschaften.

Erfindungsgemäß können beispielsweise Glaskeramiken mit einer Struktur verwendet werden, bei der die Kristallphase bzw. kristalline Phase eine negative lineare Wärmeausdehnung aufweist, während die der glasigen Phase bzw. der Glasphase positiv ist. Die besondere Zusammensetzung des Basisglases der Glaskeramik, eine definierte Kristallkeimbildung und definierte Kristallwachstumsbedingungen können dann in einem Material mit extrem geringer Wärmeausdehnung resultieren.

Da in der Regel die Kristallphase einer Glaskeramik das Ausdehnungsverhalten wesentlich bestimmt, ist der Dehnungswert des Materials insbesondere vom Strukturzustand der kristallinen Phase abhängig. Die Struktur der Kristallphase der Glaskeramik wiederum hängt im allgemeinen zum einen von der chemischen Zusammensetzung der Glaskeramik und zum anderen von den Keramisierungsbedingungen, d.h. der Temperatur und/oder der Dauer der Keramisierung ab.

Eine Glaskeramik wird in der Regel wie folgt hergestellt: Geeignete Rohmaterialien werden in einer geeigneten Zusammensetzung geschmolzen, geläutert, homogenisiert und dann zu einem Glasrohling bzw. Grünkörper heiß geformt. Unter dem "Grünkörper" einer Glaskeramik wird ein aus einer geeigneten Zusammensetzung geschmolzener glasiger Körper verstanden, welcher durch Behandeln mit einem geeigneten Temperaturprogramm in eine Glaskeramik überführt werden kann.

Nach dem Abkühlen und Tempern des erschmolzenen Grünkörpers folgt eine Temperaturbehandlung, bei welcher das Glas durch kontrollierte Volumenkristallisation in eine Glaskeramik umgewandelt wird. Während dieser Temperaturbehandlung bilden sich in einem ersten Umwandlungsschritt ("Kristallisationskeimbildung") Kristallisationskeime eigener oder fremder Art im Glas. Unter Kristallisationskeimen bzw. Kristallkeimen werden submikroskopische kristalline Aggregate einer charakteristischen Größe verstanden. In einem zweiten Umwandlungsschritt ("Kristallwachstum") ggf. bei einer etwas höheren Temperatur wachsen aus den Kristallkeimen Kristalle bzw. Kristallite.

Man ging im Stand der Technik davon aus, dass ein "Nachkeramisieren", d.h. ein erneutes Erwärmen der so hergestellten Glaskeramik auf oder über die Keramisierungstemperatur stets zu einer vollständigen und irreversiblen Umwandlung des Materials in eine Keatit-Phase führt, welche die gewünschte "Nullausdehnung" nicht mehr aufweist.

Es wurde jedoch überraschenderweise festgestellt, dass die Auftrennung der Keramisierung in mindestens zwei Schritte, d.h. ein Vorkeramisieren und mindestens ein Nachkeramisieren, möglich ist und sogar in vorteilhafter Weise ausgenutzt werden kann.

Zum einen werden Glaskeramiken oft Keramisierungsprogrammen unterworfen, welche über mehrere Wochen oder gar Monate laufen. Sofern also von einem Kunden die Anfrage nach einer Glaskeramik mit bestimmten Eigenschaften kommt, war es bisher in der Regel nicht möglich, einen solchen Kunden kurzfristig zu beliefern. Durch das Keramisieren in zwei Schritten ist es jedoch möglich, größere Chargen vorzukeramisieren und auf Lager zu halten und bei Anfrage eines Kunden den CTE der Glaskeramik durch Nachkeramisieren auf dessen Wunsch hin einzustellen. Ein solches Nachkeramisieren kann in einer wesentlich kürzeren Keramisierungszeit durchgeführt werden, da nur noch geringfügigere Änderungen des CTE erforderlich sind.

Ferner kann durch die Aufteilung in Vor- und Nachkeramisieren auch leichter eine genauere Einstellung des CTE, beispielsweise die Einstellung des Nulldurchgangs der CTE-T-Kurve, erreicht werden.

Es wurde weiter festgestellt, dass auch die Abkühlung des Grünkörpers, welcher aus den Rohstoffen erschmolzen wird, einen Einfluss auf die innere Struktur des Körpers haben kann. Unterschiedliche Abkühlraten können somit zu einer unterschiedlichen inneren Struktur des Grünkörpers führen. Diese veränderte innere Struktur kann bewirken, dass die anschließende Keramisierung nach einem bewährten Keramisierungsprogramm nicht zu einer Glaskeramik mit den gewünschten Eigenschaften führt. Da sich auch die Größe eines Körpers auf seine Abkühleigenschaften auswirkt, kann unter Umständen alleine durch die Änderung der Größe eines Körpers nicht notwendigerweise das gleiche Keramisierungsprogramm wie für einen Körper einer anderen Größe verwendet werden. Durch diese Umstände birgt eine Keramisierung vom Grünkörper zur Glaskeramik in einem Schritt das Risiko, dass auch mit einem erprobten Keramisierungsprogramm eine Glaskeramik zu lange der Temperbehandlung ausgesetzt wird und der CTE der Glaskeramik irreversibel in einen zu schlechten Bereich gefahren wird.

Erfindungsgemäß wird die Keramisierung einer Glaskeramik im oben beschriebenen zweiten Umwandlungsschritt (Kristallwachstum) und/oder der bzw. den Nachkeramisierungsschritten stets bei Temperaturen vorgenommen, bei denen sich der mittlere CTE im wesentlichen nicht verändert.

Vorzugsweise wird bei dem erfindungsgemäßen Verfahren die Glaskeramik bei einer Temperatur keramisiert, bei welcher sich der mittlere CTE in einem Bereich von $T_A$ - 50°C bis $T_A$ + 50°C, d.h. der mittlere CTE [($T_A$-50°C); ($T_A$+50°C)], vorzugsweise $T_A$ - 25°C bis $T_A$ + 25°C, d.h. der mittlere CTE [($T_A$-25°C); ($T_A$+25°C)], im wesentlichen nicht ändert. Dabei bedeutet der Begriff "eine Temperatur bei welcher sich der mittlere CTE im wesentlichen nicht ändert", dass sich der mittlere CTE einer Glaskeramik vor der Temperung durch eine Temperung bei dieser Temperatur für einen Zeitraum von mindestens 50 h, mehr bevorzugt mindestens 100 h, um höchstens $0,1 \times 10^{-6}$ /K ändert.

Bisher ging man davon aus, dass eine Steuerung dieser sehr geringfügigen Änderungen des CTE nicht durchgeführt werden kann. Es wurde nun überraschenderweise gefunden, dass genau diese geringfügige Änderung des CTE bei derartigen Keramisierungstemperaturen zum Einstellen der CTE-T-Kurve auf einen bestimmten Nulldurchgang genutzt werden kann.

Wie vorstehend beschrieben, wird der CTE zunächst von der Zusammensetzung der Glaskeramik beeinflusst. Bei einer neuen Zusammensetzung wird es somit in der Regel zunächst erforderlich sein, die Abhängigkeit der Dehnungseigenschaften von den Keramisierungsbedingungen im Temperaturbereich der späteren Anwendungstemperatur $T_A$ der Glaskeramik zu studieren. In einem solchen Fall umfasst das erfindungsgemäße Verfahren vorzugsweise den zusätzlichen Schritt des Erstellens einer $\Delta l/l_0$-T-Kurvenschar, um das Keramisierungsprogramm zu erstellen. Unter einer $\Delta l/l_0$-T-Kurvenschar wird dabei eine Reihe von mindestens zwei, vorzugsweise mehreren $\Delta l/l_0$-T-Kurven verstanden. Die Erstellung einer solchen Kurvenschar empfiehlt sich auch, wenn der Nulldurchgang der CTE-T-Kurve für eine Anwendungstemperatur eingestellt werden soll, für welche eine solche Kurvenschar noch nicht vorliegt.

Ausgehend vom gleichen Grünkörper oder einer vorkeramisierten Glaskeramik werden dazu zunächst mindestens zwei Probenkörper unter Anwendung unterschiedlicher Keramisierungsbedingungen, d.h. Keramisierungstemperatur und/oder -dauer, keramisiert bzw. nachkeramisiert. An den so hergestellten Proben werden jeweils $\Delta l/l_0$-T-Kurven bestimmt und gemeinsam in ein Diagramm eingetragen.

Zur Erstellung einer $\Delta l/l_0$-T-Kurve bzw. einer Dehnungskurve bzw. Auftragung der Längenänderung $\Delta l/l_0$ eines Probenkörpers gegen die Temperatur kann die temperaturabhängige Änderung der Länge eines Probekörpers von der Ausgangslänge $l_0$ bei der Anfangstemperatur $t_0$ auf die Länge $l_t$ bei der Temperatur t gemessen werden. Dabei werden vorzugsweise kleine Temperaturintervalle von beispielsweise 5°C oder 3°C bzw. sogar 1°C zur Bestimmung eines Messpunkts gewählt.

Solche Messungen können beispielsweise durch dilatometrische Methoden, interferometrische Methoden, beispielsweise die Methode nach Fabry-Perot, d.h. die Auswertung der Verschiebung des Resonanzpeaks eines in das Material eingekoppelten Laserstrahls, oder andere geeignete Methoden durchgeführt werden.

Die gewählte Methode zur Bestimmung der $\Delta l/l_0$-T-Messpunkte weist vorzugsweise eine Genauigkeit von vorzugsweise mindestens $\pm$ 0,10 ppm, mehr bevorzugt von $\pm$ 0,05 ppm, am meisten bevorzugt $\pm$ 0,005 (d.h. 5 ppb) und besser auf.

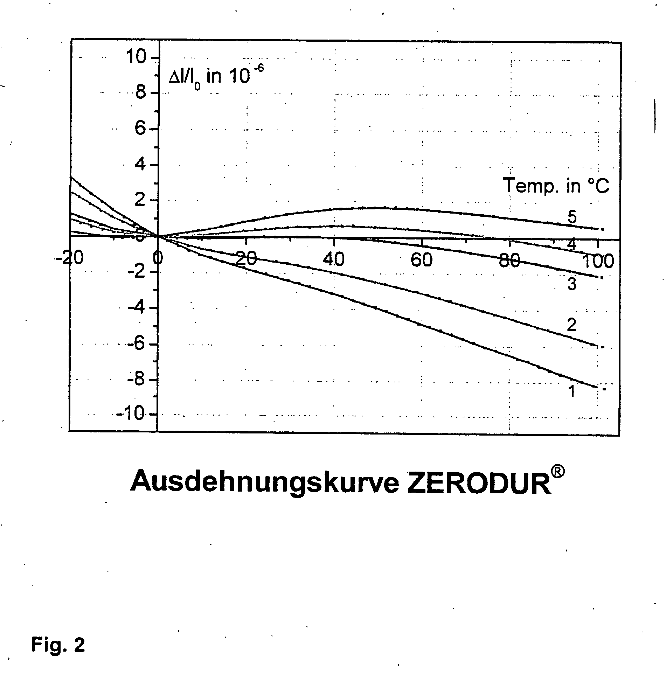

Durch die durch Messung erhaltenen Messwerte, die $\Delta l/l_0$-T-Meßwerte, wird abschließend, wie nachstehend beschrieben ein Polynom gelegt. Die Messwerte können zusammen mit dem gewählten Polynom in ein $\Delta l/l_0$-T-Diagramm eingetragen werden. Trägt man $\Delta l/l_0$-T-Messungen mehrerer, unterschiedlich keramisierter Proben in ein Diagramm ein, so wird eine wie in Figur 2 gezeigte Kurvenschar erhalten.

Figur 2 zeigt eine durch die oben beschriebene Methode erstellte Kurvenschar unterschiedlich keramisierter Zerodur®-Proben. In diesem Fall soll die Anwendungstemperatur $T_A$ der gewünschten Glaskeramik im Bereich der Raumtemperatur liegen. Dazu wurden Grünkörper einer Glaszusammensetzung und bei gleicher Keramisierungstemperatur unterschiedlich langen Keramisierungszeiten ausgesetzt. Anschließend wurde die Längenänderung $\Delta l/l_0$ des Probenkörpers, wie oben beschrieben, im Temperaturbereich von -50°C bis 100°C bestimmt, und die ermittelten Werte in ein $\Delta l/l_0$-T-Diagramm eingetragen und zu den Messwerten passende Polynome über die Messwerte gelegt.

Zur besseren Beurteilung der Entwicklung der Längenänderung und einem besseren Vergleich der durch die Messwerte gelegten Polynome bzw. Kurven im Bereich von 0 bis 50 °C wurde der Nulldurchgang aller Kurven auf 0°C gesetzt. Kurve 1 stammt von der Probe mit der kürzesten Keramisierungsdauer, welche über Kurven 2, 3 und 4 bis zu Kurve 5 ansteigt. Es ist deutlich zu erkennen, dass mit zunehmender Keramisierungsdauer der Probe sich "die Kurve gegen den Uhrzeigersinn um den Nullpunkt dreht" und dass der Kurvenverlauf im Bereich zwischen 0 bis 40°C von einer nach rechts unten absinkenden Kurve, über eine um die Nulllinie pendelnde Kurve bis zu einer nach rechts oben ansteigenden Kurve verändert. Ferner verschiebt sich das bei Raumtemperatur liegende Maximum der Kurve zunehmend zu Werten höherer Temperatur und das um 0°C liegende Minimum zu Werten niedrigerer Temperatur.

Ähnliche Ergebnisse ergeben sich, wenn die Glaskeramikproben bei konstanter Keramisierungszeit aber unterschiedlichen Keramisierungstemperaturen keramisiert werden.

Derartige aus der Kurvenschar ermittelten Erkenntnisse werden zum Anpassen des Keramisierungsprogramms verwendet. Da die Maxima und Minima der $\Delta l/l_0$-T-Kurve den Nulldurchgängen der CTE-T-Kurve entsprechen, kann aus der Kurvenschar nun abgeleitet werden, ob zum Verschieben eines bestimmten Nulldurchgangs eine längere Keramisierungszeit bzw. eine höhere Keramisierungstemperatur oder eine kürzere Keramisierungszeit bzw. eine niedrigere Keramisierungstemperatur erforderlich ist und in welchem Ausmaß eine solche Änderung der Keramisierungsbedingungen erforderlich ist.

Es wäre auch möglich, das erfindungsgemäße Verfahren nur durch Bestimmen einer $\Delta l/l_0$-T-Kurve durchzuführen und deren Minima bzw. Maxima festzustellen. Dies entspricht jedoch dem Ableiten der Kurve und ist somit von der vorliegenden Erfindung umfasst.

Bei Glaskeramiken wird im Stand der Technik der mittlere CTE stets für einen größeren Temperaturbereich angegeben, welcher mittels der folgenden Gleichung (1) bestimmt werden kann:

$$CTE\ [t_0;t] = (1\ /\ l_0) \times (l_t - l_0)\ /\ (t - t_0) = \Delta l\ /\ (l_0 \times \Delta t) \qquad (1)$$

wobei $t_0$ die Anfangstemperatur ist, t die Messtemperatur ist, $l_0$ die Probenkörperlänge bei der Anfangstemperatur $t_0$ ist, $l_t$ die Probenkörperlänge bei der Messtemperatur t und $\Delta l$ die korrigierte Längenänderung des Probenkörpers bei Temperaturänderung $\Delta t$ ist.

Zur Bestimmung eines mittleren CTE wird die Länge eines Probenkörpers einer Glaskeramik bei der Anfangstemperatur $t_0$ gemessen, der Probenkörper auf eine zweite Temperatur t erwärmt und die Länge $l_t$ bei dieser Temperatur gemessen. Aus der vorstehend genannten Formel (1) ergibt sich der mittlere CTE $[t_0; t]$ für den Temperaturbereich $t_0$ bis t.

Gemäß des erfindungsgemäßen Verfahrens ist eine derartige herkömmliche Bestimmung des mittleren CTE nicht geeignet. Durch die Betrachtung des mittleren CTE in einem Temperaturintervall wird der "wahre CTE" bei einer bestimmten Temperatur verfälscht. Eine um die Nulllinie pendelnde CTE-T-Kurve kann einen geringen niedrigen mittleren CTE vortäuschen, wohingegen der "wahre CTE" bei der Anwendungstemperatur außerhalb der Spezifikationen liegen kann. Aus den oben beschriebenen Gründen war es jedoch bisher nicht möglich mittels der üblichen Verfahren mit einem einzigen Keramisierungsschritt den CTE genauer einzustellen und eine Beeinflussung des "wahren CTE" hielt man für nicht möglich.

Unter dem "wahren CTE" bei einer bestimmten Temperatur wird der auf einer CTE-T-Kurve liegende Wert bei dieser Temperatur verstanden, wobei der Erhalt einer solchen CTE-T-Kurve vorstehend beschrieben ist.

Erfindungsgemäß wird daher der CTE als Funktion der Temperatur bestimmt und der thermische (Längen-) Ausdehnungskoeffizient CTE bzw. $\alpha$ (CTE "coefficient of thermal expansion") ist gemäß der folgenden Formel (2) definiert:

$$\text{CTE (T)} = (1 / I_0) \times (\partial I / \partial T) \qquad\qquad (2)$$

Das erfindungsgemäße Verfahren umfasst zur Ermittlung eines Keramisierungsprogramms den Schritt Ermitteln der CTE-T-Kurve einer Glaskeramik.

Zur Ermittlung der CTE-T-Kurve einer Glaskeramik in Abhängigkeit von einen Keramisierungsprogramm kann beispielsweise ein Verfahren gewählt werden, welches die folgenden Schritte umfasst:

- Bereitstellen eines Grünkörpers oder einer vorkeramisierten Glaskeramik,
- Keramisieren des Grünkörpers oder der vorkeramisierten Glaskeramik nach einem Keramisierungsprogramm,
- Ermitteln von $\Delta I/I_0$-T-Messpunkten in einem Temperaturbereich $T_A$ von beispielsweise $\pm$ 100°C, $\pm$ 50°C oder $\pm$ 25°C an der erhaltenen Glaskeramik,
- Anpassen eines Polynoms an die $\Delta I/I_0$-T-Messpunkte und
- Ableiten des Polynoms unter Erhalt einer CTE-T-Kurve.

Diese Ausführungsform wird im folgenden näher beschrieben.

Zunächst werden die $\Delta I/I_0$-T-Messwerte einer nach einem bestimmten Keramisierungsprogramm keramisierten Glaskeramik, wie vorstehend beschrieben, bestimmt.

Anschließend wird gemäß dieser Ausführungsform der vorliegenden Erfindung ein Polynom n-ten Grades, beispielsweise 4-ten Grades, so durch die $\Delta I/I_0$-T-Messpunkte gelegt, dass sich eine möglichst genaue Übereinstimmung von Messpunkten und Polynom ergibt. Vorzugsweise wird ein Polynom 3-ten bis 6-ten Grades verwendet. Ein Polynom 3-ten Grades ist oft bereits ausreichend variabel, um hinreichend genau an die Messwerte angepasst werden zu können. Polynome höheren Grades, z. B. 8-ten Grades, zeigen in der Regel eine "Schwingung", die den gemessenen Werten in der Regel nicht angemessen ist.

Ferner ist es bevorzugt, das Polynom insbesondere für den Temperaturbereich $T_A \pm$ 100°C, mehr bevorzugt $T_A \pm$ 50°C, passend auszuwählen.

Die CTE-T-Kurve kann durch Ableiten des gewählten Polynoms ermittelt werden.

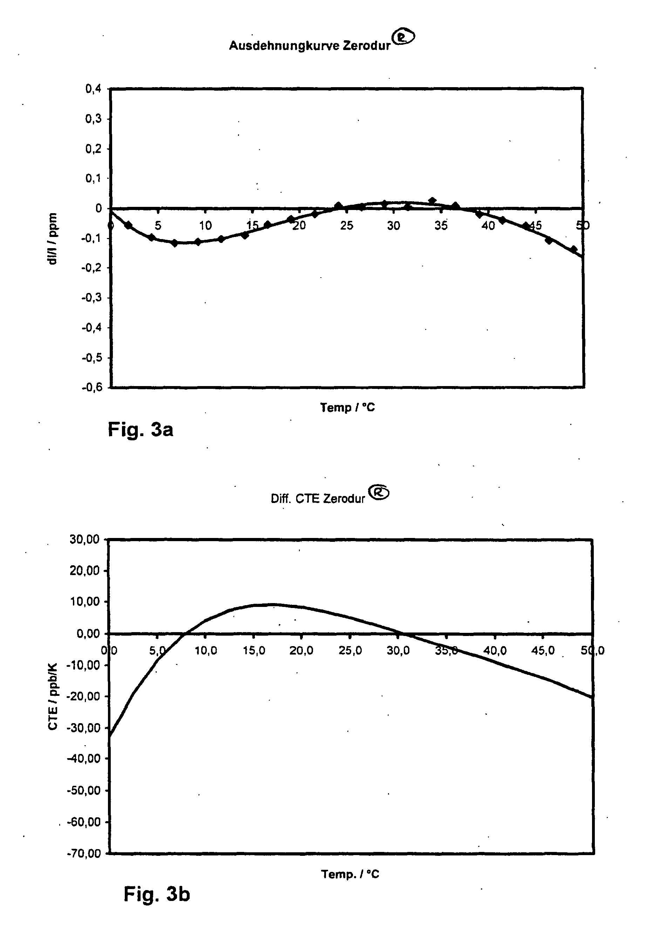

Figuren 3b bis 8b zeigen die Kurvenverläufe von Auftragungen des CTE gegen die Temperatur (CTE-T-Kurve), welche durch die oben beschriebene Ableitung von durch $\Delta I/I_0$-T-Meßpunkte gelegte Polynome bzw. Kurven bestimmt wurden, welche in Figuren 3a bis 8a gezeigt sind.

Figur 3a zeigt die $\Delta I/I_0$-T-Messpunkte von Kurve 3 aus Figur 2 und das durch diese Messpunkte gelegte Polynom in einem anderen Maßstab. Eine Ablei- , tung des Polynoms ergibt die in Figur 3b gezeigte CTE-T-Kurve, welche Nulldurchgänge der CTE-T-Kurve bei ca. 8°C und ca. 31 °C aufweist.

Sofern der Nulldurchgang der CTE-T-Kurve noch nicht bei der gewünschten Temperatur liegt, kann das Keramisierungsprogramm für einen Grünkörper oder eine vorkeramisierte Glaskeramik durch die Erkenntnisse angepasst werden, welche durch die Kurvenschar gewonnen wurden, und/oder die Glaskeramik in einem Nachkeramisierungsschritt weiterbehandelt werden.

Beispielsweise werden eine längere Keramisierungszeit und/oder höhere Keramisierungstemperaturen bzw. eine kürzere Keramisierungszeit und/oder niedrigere Temperaturen gewählt. In gewissen Fällen kann auch durch eine ggf. weitere Nachkeramisierung der Nulldurchgang der CTE-T-Kurve in den gewünschten Bereich verschoben werden.

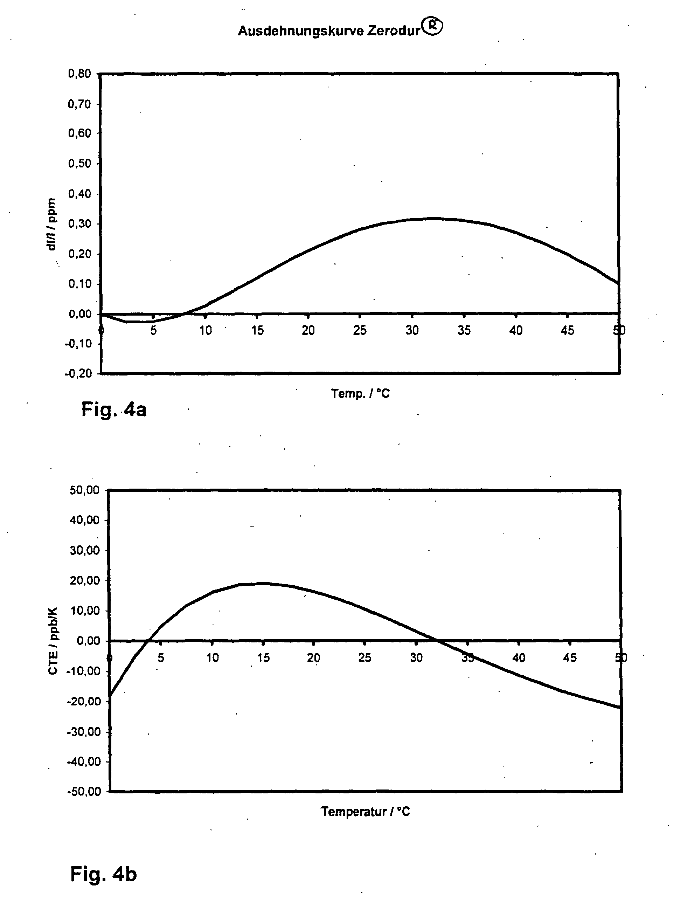

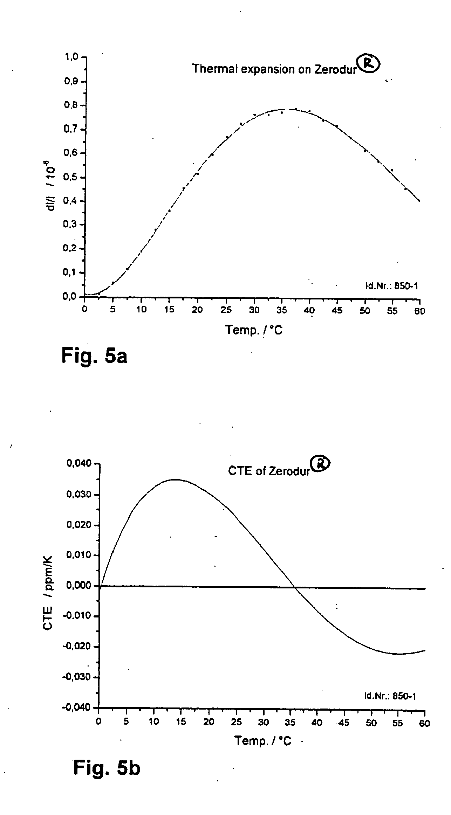

Figuren 4a und 5a zeigen $\Delta I/I_0$-T-Messpunkte bzw. durch diese Messpunkte gelegte Polynome sowie die jeweiligen Ableitungen dieser Polynome in CTE-T-Kurven in Figuren 4b und 5b, welche im Vergleich zu Figur 3b durch eine längere Keramisierungszeit verschobene Nulldurchgänge aufweisen. Der Nulldurchgang bei niedrigeren Temperaturen konnte von 8°C (Figur 3b) über 4°C (Figur 4b) auf 1°C (Figur 5b) verschoben werden. Der Nulldurchgang der CTE-T-Kurve bei etwa 31°C (Figur 3b) konnte über 33°C (Figur 4b) auf 36°C (Figur 5b) verschoben werden.

Um eine Glaskeramik der gleichen Zusammensetzung mit einem Nulldurchgang bei Raumtemperatur zu erhalten, muss in diesem Fall von einer in geringerem Ausmaß keramisierten Probe ausgegangen werden.

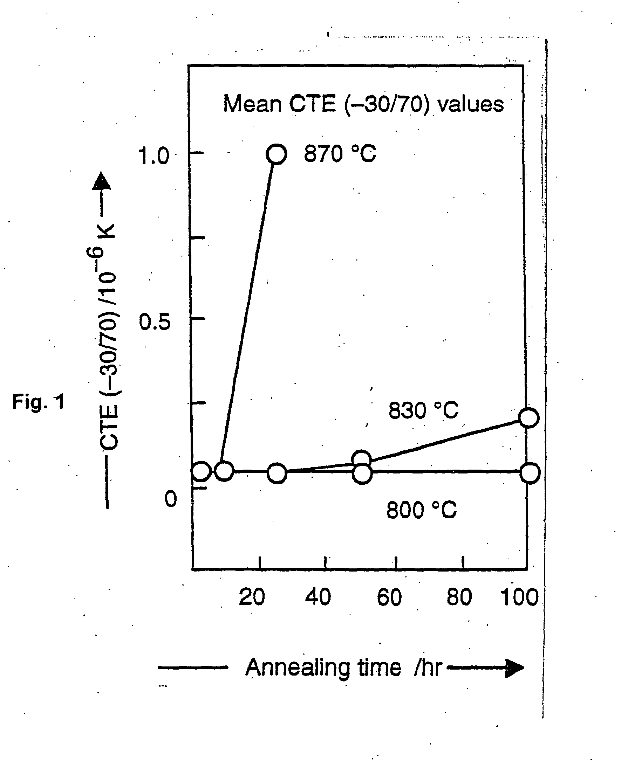

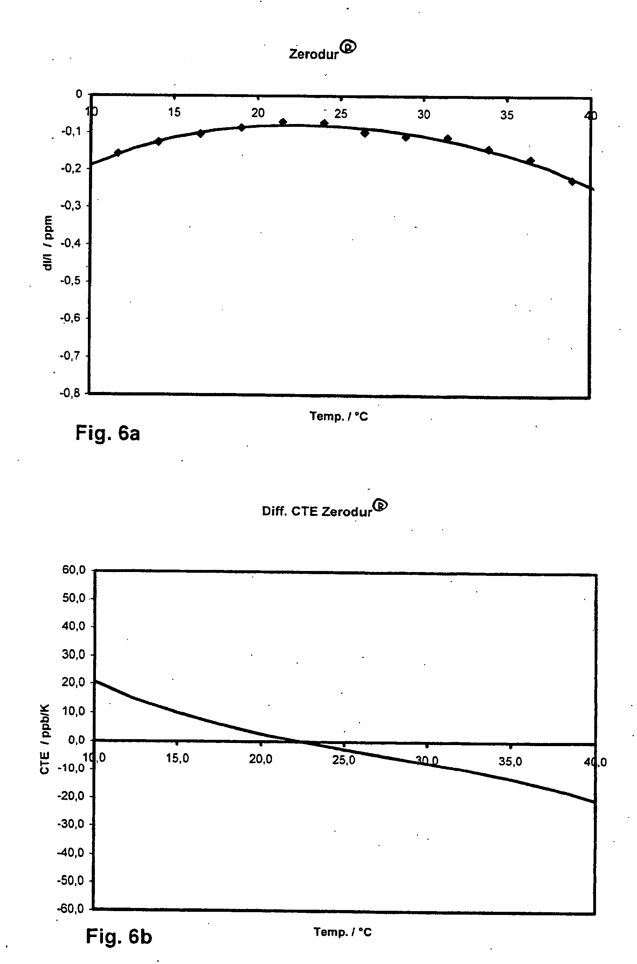

Figur 6a/b zeigt Ergebnisse von Messungen an einer Glaskeramik, welche für einen Anwendungsbereich um Raumtemperatur eingestellt wurde und daher für diesen Bereich besonders geeignet ist. In diesem Fall wurde eine vorkeramisierte Glaskeramik verwendet, welche einem mittleren CTE [0;50] von -0,1 $\times$ 10$^{-6}$/K und in etwa einen Kurvenverlauf der $\Delta$I/I$_0$-T-Kurve aufwies, welcher in etwa der Kurve 1 aus Figur 1 entsprach. Nach der Keramisierung wurden die in Figur 6a gezeigten $\Delta$I/I$_0$-Messpunkte erhalten. Nach Ableiten des durch diese Messpunkte gelegten Polynoms wurde bestätigt, dass der Nulldurchgang der CTE-T-Kurve bei etwa 23,5°C liegt. Es ergibt sich im Bereich zwischen 19 und 25°C eine äußerst geringe Abweichung des CTE vom Wert 0, welcher in diesem Temperaturbereich zwischen etwa +4 ppb/K bei 19°C und etwa -2 ppb/K bei 25°C liegt.

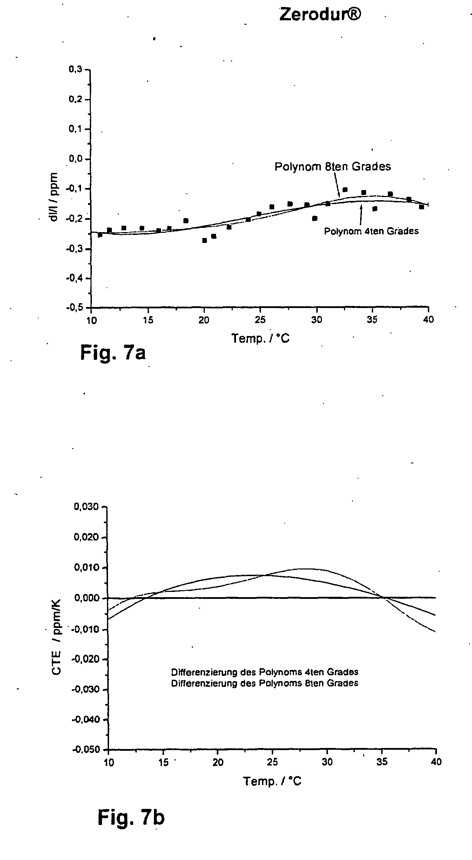

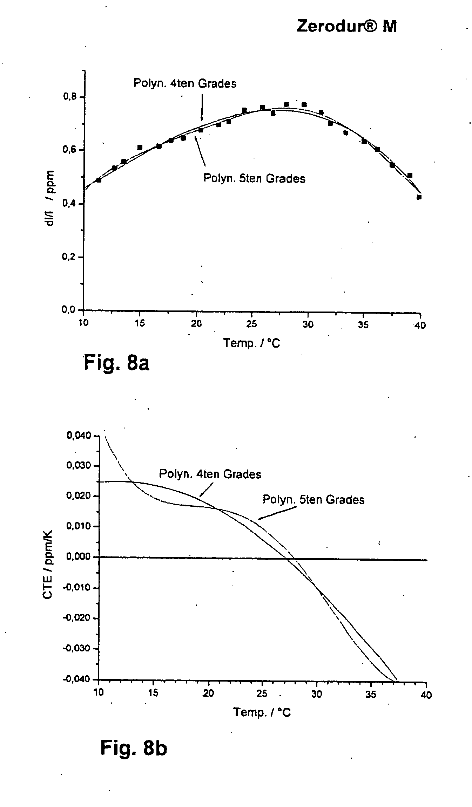

Figuren 7 und 8 zeigen die Auswirkungen auf die CTE-T-Kurve, wenn Polynome unterschiedlichen Grades durch die $\Delta$I/I$_0$-Messpunkte gelegt werden und diese dann durch Ableitung in CTE-T-Kurven überführt werden. In Figur 7 verschiebt sich der erste Nulldurchgang der CTE-T-Kurve bei ca. 13°C um ca. 2°C auf ca. 15°C, der zweite Nulldurchgang der CTE-T-Kurve liegt für beide gewählten Polynome bei ca. 35°C. Der Nulldurchgang der CTE-T-Kurve verschiebt sich in Figur 8 dadurch nur um 1°C von 24°C auf 25°C.

Somit können auch bei Wahl eines etwas anderen Polynoms, welches durch die $\Delta$I/I$_0$-Messpunkte gelegt wird, die Genauigkeit eines Nulldurchgangs der CTE-T-Kurve von $\pm$10°C, vorzugsweise $\pm$7°C, mehr bevorzugt $\pm$ 5°C, besonders bevorzugt $\pm$ 3°C, problemlos eingehalten werden.

Der Bereich, in welchem die Keramisierungstemperatur gewählt werden kann, hängt von der jeweils verwendeten Glaskeramikzusammensetzung ab. Keramisierungstemperaturen bekannter Glaskeramiken sind im Stand der Technik beschrieben und dem Fachmann bekannt (vgl. beispielsweise "Low Thermal Expansion Glas Ceramics", Schott Series on Glass and Glass Ceramics, Science, Technology, and Applications, Hans Bach (Ed.), Springer-Verlag Berlin Heidelberg, 1995).

Erfindungsgemäß ist es bevorzugt, dass bei Verwendung von Zerodur® in dem erfindungsgemäßen Verfahren Keramisierungstemperaturen, von 700 bis 830°C, mehr bevorzugt 750 bis 820°C, verwendet werden.

Figur 1 zeigt die Veränderung des mittleren CTE bei relativ hohen Keramisierungstemperaturen. Wie aus Figur 1 ersichtlich, steigt der mittlere CTE mit zunehmender Keramisierungsdauer bei Temperaturen oberhalb 830°C steil an. Die hoch-Quarz-haltigen Mischkristalle wandeln sich bei diesen hohen Temperaturen in Keatit-Mischkristalle um, welches auch zu einer Trübung der vormals transparenten Glaskeramik und einer wesentlichen Veränderung des mittleren CTE führt. Ein solches, Keatit umfassendes Material weist jedoch nicht mehr die vorteilhaften Eigenschaften einer Glaskeramik auf.

Bei Zerodur M® und Clearceram® liegen die bevorzugten Keramisierungstemperaturen niedriger, vorzugsweise in einem Bereich von 700 bis 800°C, mehr bevorzugt in 700 bis 760°C.

Im allgemeinen können auch niedrigere Temperaturen verwendet werden, so lange bei diesen Temperaturen noch eine geringfügige Änderung des mittleren CTE stattfindet.

In der Regel werden bei niedrigeren Temperaturen längere Keramisierungszeiten benötigt. Wählt man im Gegensatz dazu relative hohe Keramisierungstemperaturen, welche bei oder über den vorstehend genannten Maximaltemperaturen liegen, so ist die Keramisierungsdauer relativ kurz und der Prozess kann in Grenzfällen schlecht steuerbar sein.

Die Keramisierung kann über einen Zeitraum von mehreren Stunden bis zu mehreren Monaten durchgeführt werden.

Erfindungsgemäß kann die Keramisierung eines Grünkörpers zur Glaskeramik mit den gewünschten Eigenschaften in einer einzigen Keramisierungsstufe erfolgen, insbesondere, wenn das Keramisierungsverhalten eines Grünkörpers hinreichend bekannt ist.

Erfindungsgemäß ist es jedoch bevorzugt, eine Glaskeramik in mindestens zwei Schritten zu keramisieren. Beispielsweise kann eine bereits vorkeramisierte Glaskeramik in einem zweiten Schritt oder mehreren weiteren Schritten nachkeramisiert werden, um die Feineinstellung des Nulldurchgangs der CTE-T-Kurve zu bewirken.

Gemäß einer Ausführungsform der vorliegenden Erfindung wird eine transparente Glaskeramik verwendet. Durch die Transparenz können viele Eigenschaften einer solchen Glaskeramik, insbesondere natürlich deren optische Eigenschaften besser beurteilt werden.

Vorzugsweise wird eine Glaskeramik aus dem System Li$_2$O - Al$_2$O$_3$ - SiO$_2$ für das erfindungsgemäße Verfahren bereitgestellt.

In diesem System sind transparente Glaskeramiken mit niedrigem thermischen Ausdehnungskoeffizienten bekannt und Handelsprodukte wie Zerodur®, Zerodur® M (beide SCHOTT Glas) und Clearceram® (Ohara) können beispielhaft genannt werden. Diese Glaskeramiken enthalten üblicherweise als Hauptkristallphase etwa 50 bis 80% hoch-Quarz-haltige Mischkristalle, welche auch β-Eukryptit-Mischkristalle genannt werden. Bei diesem Kristallisationsprodukt handelt es sich um eine metastabile Phase, die in Abhängigkeit von den Kristallisationsbedingungen ihre Zusammensetzung und/oder Struktur verändert bzw. sich in eine andere Kristallphase umwandelt. Die hoch-Quarz-haltigen Mischkristalle weisen eine sehr niedrigen oder sogar bei steigender Temperatur absinkende thermische Ausdehnung auf.

Bei manchen Glaskeramiken, wie beispielsweise Zerodur®, wurde eine Abhängigkeit des CTE vom Kühlungsprogramm festgestellt. Der CTE kann sich wesentlich ändern, wenn das Abkühlen von Temperaturen oberhalb 320°C nicht mit der gleichen Kühlrate durchgeführt wird, wie die Anfangskühlrate. Daher wird das Abkühlen einer solchen Glaskeramik, wenn erforderlich, vorzugsweise entsprechend kontrolliert durchgeführt.

Die vorliegende Erfindung betrifft weiterhin ein glaskeramisches Produkt, welches nach dem erfindungsgemäßen Verfahren herstellbar ist und dessen CTE-T-Kurve so eingestellt ist, dass sie einen Nulldurchgang bei einer Temperatur $T_A \pm 10°C$, vorzugsweise $\pm 7°C$, mehr bevorzugt $\pm 5°C$, besonders bevorzugt $\pm 3°C$, aufweist. $T_A$ bezeichnet dabei die Anwendungstemperatur, d.h. die Temperatur, welcher das glaskeramische Produkt bei der bestimmungsgemäßen Anwendung ausgesetzt ist.

Gemäß der bevorzugten Ausführungsform der vorliegenden Erfindung liegt die Anwendungstemperatur $T_A$ der Glaskeramik in einem Temperaturbereich von 0°C bis 100°C.

Das mit dem erfindungsgemäßen Verfahren hergestellte glaskeramische Produkt umfasst vorzugsweise eine glaskeramische Zusammensetzung und Eigenschaften, wie vorstehend bei Beschreibung des Verfahrens beschrieben.

Durch die Einstellung des Nulldurchgangs der CTE-T-Kurve auf die Anwendungstemperatur weist ein solches glaskeramisches Produkt bei der Anwendung bei geringen Abweichungen von der Anwendungstemperatur nur einen minimalen wahren CTE, d.h. einem CTE, welcher nur wenig von 0 verschieden ist, und somit eine minimale Längenausdehnung auf, welche(r) erst mit zunehmender Entfernung von der Anwendungstemperatur langsam größer wird. Da jedoch solche größeren Abweichungen von der Anwendungstemperatur bei Verfahren mit kontrollierten Verfahrensbedingungen zumindest während der Durchführung des Verfahrens in der Regel nicht auftreten, ist für solche Anwendungen alleine der Bereich um die Anwendungstemperatur entscheidend und der erfindungsgemäße Effekt kommt voll zum Tragen.

Wird hingegen nur der mittlere CTE eines glaskeramischen Produkts eingestellt, so kann die CTE-T-Kurve im Anwendungsbereich je nach Charge unterschiedlich ausfallen, und der wahre CTE kann ungünstigerweise gerade bei der Anwendungstemperatur vergleichsweise weit von der Nulllinie entfernt sein.

Mit dem erfindungsgemäßen Verfahren kann ein ein glaskeramisches Produkt aus dem System $Li_2O$ - $Al_2O_3$ - $SiO_2$ hergestellt werden, welches einen mittleren CTE $[(T_A-50°C);(T_A+50°C)]$, vorzugsweise einen mittleren CTE $[(T_A-25°C);(T_A+25°C)]$, mehr bevorzugt einen mittleren CTE $[(T_A-10°C);(T_A+10°C)]$, am meisten bevorzugt einen mittleren CTE $[(T_A-5°C);(T_A+5°C)]$, von höchstens $0 \pm 10$ ppb/K, vorzugsweise höchstens $0 \pm 5$ ppb/K, vorzugsweise höchstens $0 \pm 3$ ppm/K, aufweist. Die Anwendungstemperatur $T_A$ liegt dabei vorzugsweise in einem Bereich von 0°C bis 100°C, beispielsweise bei 10°C, 20°C, 30°C, 40°C oder 50°C. Diese Ausführungsform der vorliegenden Erfindung umfasst vorzugsweise eine glaskeramische Zusammensetzung und Eigenschaften, wie es vorstehend bei Beschreibung des Verfahrens beschrieben ist.

Erfindungsgemäß resultiert die Längenänderung solcher glaskeramischen Produkte bei Anwendungstemperaturen vorzugsweise im wesentlichen nur aus reversiblen Längenänderungen.

Vorzugsweise wird das erfindungsgemäße Verfahren zur Herstellung glaskeramischen Produkten verwendet, welche in der Mikrolithographie, der Metrologie, beispielsweise für Endmaße, und/oder in der Astronomie, beispielsweise als Substrat für einen Spiegel, angewendet werden.

Je nach Verwendung des glaskeramischen Produkts kann die Anwendungstemperatur $T_A$ in unterschiedlichen Temperaturbereichen liegen. Beispielsweise sind für Anwendungen in der EUV-Mikrolithographie und der Metrologie Temperaturen im Bereich der Raumtemperatur typisch, wohingegen in der Astronomie auch Temperaturen weit unter dem Nullpunkt nicht ungewöhnlich sind.

Ferner kann mit dem erfindungsgemäßen Verfahren ein Substrat für insbesondere die EUV-Lithographie, welches ein wie vorstehend beschriebenes glaskeramisches Produkt umfasst. Vorzugsweise umfasst ein solches Substrat eine Glaskeramik mit einem niedrigen Ausdehnungskoeffizienten. Vorzugsweise liegt die Temperatur $T_A$ in einem Bereich von 0 bis 50°C, mehr bevorzugt in einem Bereich von 10 bis 40°C, besonders bevorzugt in einem Bereich von 19 bis 31°C. Vorzugsweise dienen solche Substrate als Substrate für Spiegel und/oder Masken bzw. Mask Blanks für die EUV-Lithographie.

Das erfindungsgemäße Verfahren eignet sich auch zur Durchführung eines Verfahren zur Herstellung einer Glaskeramik aus dem System $Li_2O$ - $Al_2O_3$ - $SiO_2$, umfassend die Schritte

- Bereitstellen eines Grünkörpers einer Glaskeramik,
- Vorkeramisieren des Grünkörpers zu einer vorkeramisierten Glaskeramik und
- Nachkeramisieren der vorkeramisierten Glaskeramik zu einer Glaskeramik mit einen mittlerem CTE $[(T_A-50°C);(T_A+50°C)]$ von höchstens $0,1 \times 10^{-6}$/K, vorzugsweise höchstens $0,05 \times 10^{-6}$/K, mehr bevorzugt von höchstens $0,01 \times 10^{-6}$/K.

Für dieses Verfahren gilt das für das vorstehend genannte Verfahren beschriebene in gleicher Weise.

**Beispiel**

Eine vorkeramisierte Zerodur®-Probe mit einem mittleren CTE [0;50] von $-0,1 \times 10^{-6}$/K und in etwa der $\Delta l/l_0$-Kur-

EP 1 321 440 B1

ve 1 aus Figur 2 wurde bei einer Maximaltemperatur von 810°C für 60 h nachkeramisiert. Es wurde eine Glaskeramik mit den in Figuren 3a und 3b gezeigten Dehnungseigenschaften erhalten.

**Patentansprüche**

1. Verfahren zur Herstellung einer Glaskeramik aus dem System $Li_2O$ - $Al_2O_3$

   - $SiO_2$, wobei die Glaskeramik hauptsächlich hoch-Quarz-haltige Mischkristalle enthält, deren Nulldurchgang der CTE-T-Kurve in einem Bereich $T_A \pm 10°C$ um eine Anwendungstemperatur $T_A$ eingestellt ist, **dadurch gekennzeichnet, dass** es die Schritte
   - Bereitstellen einer vorkeramisierten Glaskeramik , wobei das Vorkeramisieren die Kristallisationskeimbildung und Kristallwachstum umfasst, und
   - Nachkeramisieren nach einem Keramisierungsprogramm und **dadurch** Einstellen des Nulldurchgangs der CTE-T-Kurve der Glaskeramik, wobei die Glaskeramik auf oder über die Keramisierungstemperatur erwärmt wird,

   umfasst, wobei die Erstellung des Keramisierungsprogramms den Schritt Ermitteln der CTE-T-Kurve umfasst und wobei "CTE" für den thermischen Längenausdehnungskoeffizienten ($\alpha$) steht.

2. Verfahren nach Anspruch 1, wobei eine Glaskeramik bereitgestellt wird, welche einen mittlerem CTE $[(T_A\text{-}50°C);(T_A\text{+}50°C)]$ von höchstens $1{,}0 \times 10^{-6}$/K aufweist.

3. Verfahren nach einem der vorangehenden Ansprüche, wobei zur Bestimmung des Keramisierungsprogramms eine $\Delta l/l_0$-T-Kurvenschar erstellt wird.

4. Verfahren nach einem der vorangehenden Ansprüche, wobei bei einer Temperatur keramisiert wird, bei welcher sich der mittlere CTE $[T_A\text{-}50;T_A\text{+}50]$ im wesentlichen nicht ändert.

5. Verfahren zur Herstellung einer Glaskeramik aus dem System $Li_2O$ - $Al_2O_3$

   - $SiO_2$, wobei die Glaskeramik hauptsächlich hoch-Quarz-haltige Mischkristalle enthält **dadurch gekennzeichnet, dass** es die Schritte
   - Bereitstellen eines Grünkörpers einer Glaskeramik,
   - Vorkeramisieren des Grünkörpers zu einer vorkeramisierten Glaskeramik, wobei das Vorkeramisieren die Kristallisationskeimbildung und Kristallwachstum umfasst,
   - Nachkeramisieren der vorkeramisierten Glaskeramik zu einer Glaskeramik mit einen mittlerem CTE $[(T_A\text{-}50°C);(T_A\text{+}50°C)]$ von höchstens $0{,}1 \times 10^{-6}$/K, wobei die Glaskeramik auf oder über die Keramisierungstemperatur erwärmt wird, umfasst wobei $T_A$ die Anwendungstemperatur der Glaskeramik ist und wobei "CTE" für den thermischen Längenausdehnungskoeffizienten ($\alpha$) steht.

6. Verwendung eines Verfahrens nach einem der Ansprüche 1 bis 5 zur Herstellung eines glaskeramischen Produktes für die Metrologie, die Astronomie oder die Mikrolithographie.

**Claims**

1. Process for producing a glass-ceramic from the $Li_2O$ - $Al_2O_3$ - $SiO_2$ system, the glass-ceramic predominantly containing beta-quartz solid solutions of which the zero crossing of the CTE-T curve is set in a range $T_A\pm 10°C$ around an application temperature $T_A$, **characterized in that** it comprises the steps of

   - providing a pre-ceramicized glass-ceramic, the pre-ceramicizing comprising crystallization nucleation and crystal growth, and
   - post-ceramicizing in accordance with a ceramicizing programme, and thereby setting the zero crossing of the CTE-T curve of the glass-ceramic, the glass-ceramic being heated to or beyond the ceramicizing temperature,

   the drawing-up of the ceramicizing programme comprising the step of determining the CTE-T curve, where "CTE" stands for the coefficient of thermal expansion ($\alpha$).

9

**2.** Process according to Claim 1, which involves providing a glass-ceramic which has a mean CTE [($T_A$-50°C); ($T_A$+50°C)] of at most $1.0 \times 10^{-6}$/K.

**3.** Process according to one of the preceding claims, in which a $\Delta l/l_0$-T curve set is drawn up to determine the ceramicizing programme.

**4.** Process according to one of the preceding claims, in which ceramicizing is carried out at a temperature at which the mean CTE [$T_A$-50;$T_A$+50] substantially does not change.

**5.** Process for producing a glass-ceramic from the $Li_2O$ - $Al_2O_3$ - $SiO_2$ system, the glass-ceramic predominantly containing beta-quartz solid solutions **characterized in that** it comprises the steps of

- providing a green body for a glass-ceramic,
- pre-ceramicizing the green body to form a pre-ceramicized glass-ceramic, the pre-ceramicizing comprising crystallization nucleation and crystal growth,
- post-ceramicizing the pre-ceramicized glass-ceramic to form a glass-ceramic with a mean CTE [($T_A$-50°C); ($T_A$+50°C)] of at most $0.1 \times 10^{-6}$/K, the glass-ceramic being heated to or beyond the ceramicizing temperature, $T_A$ being the application temperature of the glass-ceramic and "CTE" standing for the coefficient of thermal expansion ($\alpha$).

**6.** Use of a process according to one of Claims 1 to 5 for producing a glass-ceramic product for metrology, astronomy or microlithography.

**Revendications**

**1.** Procédé en vue de la fabrication d'une vitro-céramique à partir du système $Li_2O$ - $Al_2O_3$ - $SiO_2$, la vitro-céramique contenant principalement des cristaux mixtes contenant une forte proportion de quartz, dont le passage par zéro de la courbe CTE-T est réglé dans un domaine $T_A \pm$ 10°C autour d'une température d'application $T_A$, **caractérisé en ce qu'**il comprend les étapes

- de mise à disposition d'une vitro-céramique pré-céramisée, l'opération de céramisation préalable comprenant la formation de germes de cristallisation et la croissance des cristaux, et
- de post-céramisation, conformément à un programme de céramisation, et, par conséquent, de réglage du passage par zéro de la courbe CTE-T de la vitro-céramique, la vitro-céramique étant échauffée à ou au-dessus de la température de céramisation,

la réalisation du programme de céramisation comprenant l'étape de détermination de la courbe CTE-T et « CTE » désignant le coefficient de dilation longitudinale thermique ($\alpha$).

**2.** Procédé selon la revendication 1, une vitro-céramique étant mise à disposition, laquelle présente une valeur moyenne CTE [($T_A$-50°C);($T_A$+50°C)] d'au plus 1,0 x $10^{-6}$/K.

**3.** Procédé selon l'une quelconque des revendications précédentes, une série de courbes $\Delta l/l_0$-T étant établie en vue de la détermination du programme de céramisation.

**4.** Procédé selon l'une quelconque des revendications précédentes, la céramisation ayant lieu à une température à laquelle la valeur moyenne CTE [($T_A$-50°C);($T_A$+50°C)] ne se modifie pas substantiellement.

**5.** Procédé en vue de la fabrication d'une vitro-céramique à partir du système $Li_2O$ - $Al_2O_3$ - $SiO_2$, la vitro-céramique contenant principalement des cristaux mixtes contenant une forte proportion de quartz, **caractérisé en ce qu'**il comprend les étapes

- de mise à disposition d'une verre précursor d'une vitro-céramique,
- d'une opération de céramisation préalable du corps de base pour former une vitro-céramique pré-céramisée, l'opération de céramisation préalable comprenant la formation de germes de cristallisation et la croissance des cristaux,
- de post-céramisation de la vitro-céramique pré-céramisée pour former une vitro-céramique ayant une valeur moyenne CTE [$(T_A-50°C);(T_A+50°C)$] d'au plus 0,1 x $10^{-6}$/K, la vitro-céramique étant échauffée à ou au-dessus de la température de céramisation, $T_A$ étant la température d'application de la vitro-céramique et « CTE » désignant le coefficient de dilation longitudinale thermique ($\alpha$).

6. Utilisation d'un procédé selon l'une quelconque des revendications 1 à 5 en vue de la fabrication d'un produit vitro-céramique pour la métrologie, l'astronomie ou la micro lithographie.

Fig. 1

Mean CTE (−30/70) values

870 °C

830 °C

800 °C

CTE (−30/70) /10⁻⁶ K →

Annealing time /hr →

**Ausdehnungskurve ZERODUR®**

Fig. 2

Ausdehnungkurve Zerodur®

Fig. 3a

Diff. CTE Zerodur®

Fig. 3b

Ausdehnungskurve Zerodur®

Fig. 4a

Fig. 4b

**Fig. 5a**

**Fig. 5b**

Zerodur®

**Fig. 6a**

Diff. CTE Zerodur®

**Fig. 6b**

## Zerodur®

**Fig. 7a**

**Fig. 7b**

Zerodur® M

Fig. 8a

Fig. 8b